# EUROPÄISCHE PATENTSCHRIFT

(11) **EP 3 794 638 B1**
(45) Veröffentlichungstag und Bekanntmachung des Hinweises auf die Patenterteilung: **15.06.2022**
(21) Anmeldenummer: 19726586.1
(22) Anmeldetag: 14.05.2019
(51) Int. Cl.: H01L 23/473, H01L 23/373, H01L 21/48, H01L 23/15, H05K 7/20

(54) **SYSTEM ZUM KÜHLEN EINES METALL-KERAMIK-SUBSTRATS, EIN METALL-KERAMIK- SUBSTRAT UND VERFAHREN ZUM HERSTELLEN DES SYSTEMS**
SYSTEM FOR COOLING A METAL-CERAMIC SUBSTRATE, A METAL-CERAMIC SUBSTRATE AND METHOD FOR PRODUCING SAID SYSTEM
SYSTÈME DESTINÉ À REFROIDIR UN SUBSTRAT DE MÉTAL ET DE CÉRAMIQUE, SUBSTRAT DE MÉTAL ET DE CÉRAMIQUE, ET PROCÉDÉ DESTINÉ À FABRIQUER LE SYSTÈME

(30) Priorität: 18.05.2018 DE 102018112000
(43) Veröffentlichungstag der Anmeldung: 24.03.2021
(73) Patentinhaber: Rogers Germany GmbH, 92676 Eschenbach (DE)
(72) Erfinder: MEYER, Andreas, 95469 Speichersdorf (DE); GIL, Vitalij, 91217 Hersbruck (DE); MÜLLER, László, 91207 Lauf a. d. Pegnitz (DE); HERRMANN, Rainer, 95485 Warmensteinach (DE); BRITTING, Stefan, 91220 Schnaittach (DE)
(74) Vertreter: Müller Schupfner & Partner Patent- und Rechtsanwaltspartnerschaft mbB
(86) Internationale Anmeldenummer: PCT/EP2019/062302
(87) Internationale Veröffentlichungsnummer: WO 2019/219656

(56) Entgegenhaltungen:
- EP-A1- 2 840 875
- WO-A1-2015/027995
- DE-A1-102015 114 291
- DE-A1-102016 125 338
- DE-B3-102014 112 516
- DE-U1-202009 005 305
- US-A1- 2006 108 098

## Beschreibung

Die vorliegende Erfindung betrifft ein System zum Kühlen eines Metall-Keramik-Substrats, ein Verfahren zu dessen Herstellung und ein Metall-Keramik-Substrat.

Metall-Keramik-Substrate sind beispielsweise als Leiterplatten oder Platinen bekannt. Typischerweise werden auf einer Bauteilseite des Metall-Keramik-Substrats elektrische Bauteile oder -elemente und Leiterbahnen angeordnet, wobei die elektrischen Bauteile und die Leiterbahnen zu elektrischen Schaltkreisen zusammenschaltbar sind. Für Spezialanwendungen haben sich solche Metall-Keramik-Substrate als besonders vorteilhaft erwiesen, die zur elektrischen Isolation der einzelnen elektrischen Bauteile und Leiterbahnen eine Isolationsschicht mit hoher elektrischer Isolationsfestigkeit aufweisen, wie z.B. eine aus einer entsprechenden Keramik gefertigte Isolationsschicht.

Im Betrieb dieser Metall-Keramik-Substrate werden die elektrischen Bauteile typischerweise derart beansprucht, dass sie erhitzen und sich auf der Bauteilseite lokale Wärmequellen ausbilden. Um durch das Erhitzen veranlasste Schädigungen an den elektrischen Bauteilen oder dem Metall-Keramik-Substrat zu vermeiden, kennt der Stand der Technik, z.B. aus der DE 10 2012 200 325 A1 oder der DE 10 2014 105 727 A1, Kühlstrukturen, über die sich die Wärme von dem Metall-Keramik-Substrat abtransportieren lässt. Als besonders wirkungsvoll hat es sich dabei erwiesen, einen Wärmeaustausch mit einer an der Kühlstruktur vorbeiströmenden Kühlflüssigkeit zum Wärmeabtransport zu nutzen. Mit der Entwicklung neuartiger elektrischer Bauteile, beispielsweise aus Halbleiterelementen wie SiC oder GaN, steigen allerdings auch die an die Kühlsysteme gestellten Anforderungen in Hinblick auf die Kühlperformance. Darüber hinaus begrenzt die Wirkungsweise der Kühlsysteme aus dem Stand der Technik mitunter die Dimensionierung einer Kühlstruktur für ein Metall-Keramik-Substrat.

Die WO 2015 027995 A1 und die DE 10 2015 114 291 A1 offenbaren Verteilstrukturen aus Metall bzw. Keramik.

Die DE 10 2016 125 338 A1 beschreibt ein System zum Kühlen eines für elektrische Bauteile vorgesehenen Trägersubstrats, wobei das Trägersubstrat eine Bauteilseite und eine der Bauteilseite gegenüberliegende Kühlseite mit einer Kühlstruktur aufweist und das System ein Schalenelement umfasst, das derart ausgestaltet ist, dass das an dem Trägersubstrat befestigte Schalenelement zusammen mit der Kühlseite des Trägersubstrats einen Fluidkanal bildet.

Aus der DE 20 2009 005 305 U1 ist ein Kühlsystem mit einem Oberdeckel und einer Bodenplatte bekannt. Dabei ist die Bodenplatte aus Metall und der Oberdeckel aus Kunststoff.

Es ist eine Aufgabe der vorliegenden Erfindung, ein Kühlsystem bereitzustellen, mit dem die Kühlperformance für Metall-Keramik-Substrate gegenüber jenen aus dem Stand der Technik weiter verbessert ist.

Diese Aufgabe wird gelöst durch ein System zum Kühlen eines Metall-Keramik-Substrats gemäß Anspruch 1, ein Metall-Keramik-Substrat gemäß Anspruch 8 sowie ein Verfahren zum Herstellen des Systems gemäß Anspruch 9 Weitere Vorteile und Merkmale der Erfindung ergeben sich aus den Unteransprüchen sowie der Beschreibung und den beigefügten Figuren.

Erfindungsgemäß ist ein System zum Kühlen eines Metall-Keramik-Substrats mit einer Bauteilseite und einer der Bauteilseite gegenüber liegenden Kühlseite vorgesehen. Dabei umfasst das System
- eine metallische Kühlstruktur mit mindestens einem integrierten Fluidkanal zur Führung eines Fluids innerhalb der Kühlstruktur und
- eine Verteilstruktur aus Kunststoff zur Versorgung des Fluidkanals mit dem Fluid.

Weiterhin ist es vorgesehen, dass die Kühlstruktur an seiner der Verteilstruktur zugewandten Außenseite eine Eingangsöffnung und eine von der Eingangsöffnung separate Ausgangsöffnung aufweist, wobei die Eingangsöffnung und die Ausgangsöffnung über den Fluidkanal miteinander verbunden sind und der Fluidkanal derart gestaltet ist, dass das Fluid in der verbauten Kühlstruktur von der Eingangsöffnung in Richtung der Bauteilseite geführt und innerhalb der Kühlstruktur umgelenkt wird.

Gegenüber den aus dem Stand der Technik bekannten Systemen zum Kühlen zeichnet sich das erfindungsgemäße System durch die besonders gezielte Führung des Fluids aus. Dabei beginnt die kontrollierte Führung bereits mit der Verteilstruktur, mit der das Fluid zur Eingangsöffnung des Fluidkanals geführt wird. Anschließend wird das Fluid entlang eines festgelegten Strömungsverlaufs innerhalb der Kühlstruktur in Richtung der Bauteilseite transportiert und wieder aus der Kühlstruktur herausgefördert. Dabei erweist sich die gezielte Führung innerhalb der Kühlstruktur als vorteilhaft, weil diese Führung es beispielswiese erlaubt, Verwirbelungen zu erzeugen oder eine Kontaktfläche zwischen der Metallischen Kühlstruktur und dem Fluid signifikant zu vergrößern, wodurch wiederum eine Kühlperformance der Kühlstruktur verbessert wird. Darüber hinaus sorgt die Verteilstruktur dafür, dass keine Flüssigkeit in die bzw. zur Ausgangsöffnung geleitet wird. Mit anderen Worten: die Verteilstruktur stellt durch die gezielte Zuführung des Fluid zu den Eingangsöffnungen sicher, dass keine unerwünschte Gegenströmung innerhalb des Fluidkanals auftritt und unterstützt eine Strömungsrichtung bzw. -vorgabe innerhalb des Fluidkanals. Ferner lässt sich mit der Verteilstruktur die Verteilung des Fluid auf mehre Fluidkanäle so steuern, dass diese gleichermaßen mit gleichtemperierte Fluid, versorgt werden, d. h. es lässt sich vermeiden, das bereits zum Kühlen genutztes Fluid mehrfach verwendet wird. Dies wirkt sich positiv auf die Homogenität beim Kühlen der gesamten bzw. vollständigen Kühlseite aus.

Durch die Ausgestaltung der Verteilstruktur aus Kunststoff lässt sich diese zudem vergleichsweise einfach und kostengünstig, beispielsweise durch ein Spritzguss und/oder Pressgussverfahren, herstellen. Insbesondere liegt die Verteilstruktur im verbauten Zustand unmittelbar an der Außenseite der Kühlstruktur an. Dabei kommt der Verteilstruktur vorzugsweise die Aufgabe zu, das Fluid, das mittels einer Zuführstruktur entlang einer ersten Hauptströmungsrichtung transportiert wird, derart umzulenken, dass zumindest ein Teil des von der Zuführstruktur geführten Fluid zur Eingangsöffnung umgelenkt wird. Hierfür ist es nicht zwingend erforderlich, dass die Verteilstruktur und die Außenseite der Kühlstruktur abgedichtet sind. Weiterhin ist es vorgesehen, dass die Verteilstruktur zwischen der Zuführstruktur und der Kühlstruktur angeordnet ist. Beispielswiese wird die Verteilstruktur von der Zuführstruktur umschlossen bzw. umgeben. Vorzugsweise ist es vorgesehen, dass der Fluidkanal in einer senkrecht zur Strömungsrichtung (in der Kühlstruktur) verlaufenden Ebene einen Öffnungsquerschnitt aufweist, dessen Durchmesser kleiner als 2 mm, bevorzugt kleiner als 1,5 mm und besonders bevorzugt kleiner als 1 mm oder 0,5 mm ist. Dadurch lässt sich das Fluid mit einer vergleichsweise hohen räumlichen Auflösung gezielt an die gewünschte Position führen. Ferner ist es dadurch möglich, für eine homogene Temperaturverteilung in der Kühlstruktur die Außenseite der Kühlstruktur mit mehreren Fluidkanälen zu versehen, wobei die Verteilstruktur vorzugsweise mehrere Eingangsöffnungen, vorzugsweise eine Teilmenge aller Eingangsöffnungen, mit dem Fluid versorgt. Weiterhin ist es vorstellbar, dass der Öffnungsquerschnitt quadratische, rechteckig, elliptisch bzw. kreisförmig ist.

Die Verteilstruktur weist vorzugsweise neben einem einleitenden Teil, über den das Fluid in die Eingangsöffnung eingeleitet wird auch einen ausleitenden Teil auf, über den das Fluid von der Ausgangsöffnung vom Fluidkanal weggeführt wird, auf. Mit anderen Worten; die Verteilstruktur sorgt nicht nur für die Versorgung der Eingangsöffnungen mit dem Fluid, sondern stellt auch einen kontrollierten Ablauf von der Ausgangsöffnung sicher. Dabei grenzt der einleitenden Teil bevorzugt an die Eingangsöffnung und der ausleitenden Teil an die Ausgangsöffnung, insbesondere unmittelbar, an. Weiterhin ist es vorstellbar, dass die Verteilstruktur derart gestaltet ist, dass sie dafür sorgt, dass entlang der Ausgangsöffnung keine parallel zur Haupterstreckungsebene verlaufende Strömung erfolgt bzw. auftritt bzw. diese reduziert ist. Dadurch wird in vorteilhafter Weise verhindert, dass das aus der Ausgangsöffnung austretende Fluid von der andernfalls dort herrschenden Strömung beeinträchtigt wird.

Gemäß einer bevorzugten Ausführungsform der vorliegenden Erfindung ist es vorgesehen, dass die Kühlstruktur, insbesondere der Fluidkanal, und/oder die Verteilstruktur derart gestaltet sind, dass eine Strömungsrichtung des Fluid nach Verlassen der Verteilstruktur, z. B. entlang einer zweiten Hauptströmungsrichtung, in einer parallel zur Haupterstreckungsebene verlaufenden Richtung seitlich versetzt ist gegenüber einer Strömungsrichtung des Fluid beim Eintritt in die Verteilstruktur, z. B. entlang einer ersten Hauptströmungsrichtung. Dabei kann der Versatz beispielsweise ausschließlich durch den Fluidkanal oder ausschließlich durch die Verteilstruktur erfolgen. Insbesondere wird das Fluid gegenüber der ersten Hauptströmungsrichtung seitlich versetzt und fließt entlang einer zweiten Hauptströmungsrichtung weiter. Unter "seitlich" ist insbesondere ein Querversatz gegenüber der ersten Hauptströmungsrichtung zu verstehen. Vorzugsweise ist der seitliche Versatz derart groß, dass sich - entlang einer parallel zur ersten Hauptströmungsrichtung verlaufenden Richtung betrachtet - Strömungsquerschnitte (bemessen senkrecht zur ersten bzw. zweiten Hauptströmungsrichtung) nicht überlappen bzw. überschneiden. Mit anderen Worten. Nach dem Verlassen des Systems aus Kühlstruktur und Verteilstruktur ist das vom Fluidkanal geführte Fluid lateral bzw. seitlich versetzt. Dadurch kann in vorteilhafter Weise vermieden werden, dass ein bereits zum Kühlen verwendetes Fluid, d. h. ein verbrauchtes Fluid, mit einem frischen Fluid bzw. frischem Teil des Fluids vermischt wird, d. h. zugeführtes Fluid und abgeführtes Fluid werden voneinander getrennt unterhalb der Kühlstruktur weitergeführt. Auf diese Weise kann sichergestellt werden, dass entlang der erster Hauptströmungsrichtung gesehen hintere Fluidkanäle mit einem Fluid versorgt werden, dessen Temperatur im Wesentlichen der Temperatur entspricht, die ein Fluid aufweist, das in ein entlang der ersten Hauptströmungsrichtung gesehen vorderer Fluidkanal eingeleitet wird. Dies trifft hier insbesondere zu, wenn mehrere Verteilstrukturen entlang der ersten Hauptströmungsrichtung bzw. entlang der ersten Hauptströmungsrichtung gesehen hintereinander angeordnet sind bzw. hintereinander geschaltet sind. Dadurch lässt sich in vorteilhafter Weise eine möglichst homogene Kühlung auf der Kühlseite gewährleisten. Wenn in dieser Anmeldung von Fluid gesprochen wird, sind hier insbesondere Teile eines gemeinsamen zur Kühlung gedachten Fluids gemeint. Vorzugsweise handelt es sich bei dem Fluid um eine Flüssigkeit.

Erfindungsgemäß sind mehrere Fluidkanäle mit jeweils einer Eingangsöffnung in einer Reihenrichtung gesehen nebeneinander angeordnet sind und/oder die Verteilstruktur ist derart gestaltet, dass sie mehrere Eingangsöffnungen, insbesondere nebeneinander angeordnete Eingangsöffnungen, mit dem Fluid versorgt. Dabei kann die Reihenrichtung parallel zur ersten Hauptströmungsrichtung und/oder schräg, insbesondere senkrecht zur ersten Hauptströmungsrichtung, ausgerichtet sein. Weiterhin sind die Ausgangsöffnungen ebenfalls entlang einer Reihenrichtung nebeneinander angeordnet, insbesondere parallel versetzt zu den Eingangsöffnungen. Vorzugsweise gibt die Reihenrichtung nur einen generellen Verlauf wieder und die benachbarten Fluidkanäle können innerhalb von Grenzen (insbesondere festgelegt durch die Verteilstruktur) zueinander versetzt sein. Weiterhin ist es vorstellbar, dass die Verteilstruktur, insbesondere der einleitenden Teil, derart gestaltet ist, dass die Eingangsöffnungen der Fluidkanäle in einer Reihe mit einem Fluid versorgt werden, wobei das Fluid im Wesentlichen - unabhängig von der Eingangsöffnung und dem zurückzulegenden Weg für das Fluid - die gleiche Temperatur aufweist. Beispielsweise umfasst die Verteilstruktur, insbesondere der einleitenden Teil, hierzu eine rampenförmige Struktur, wobei die rampenförmige Struktur so geneigt ist, dass ein Abstand zwischen der rampenförmigen Struktur und der Außenseite der Kühlstruktur mit zunehmenden zurückgelegten Weg des Fluids kleiner wird. Dadurch kann sich eine Strömung einstellen, die eine homogene Kühlung mit dem Fluid gestattet.

Bevorzugt ist es vorgesehen, dass der Fluidkanal U-förmig gestaltet ist, wobei der U-förmig gestaltete Fluidkanal zwei im Wesentlichen senkrecht zur Haupterstreckungsebene verlaufende Schenkelbereiche und einen die beiden Schenkelbereich verbindenden Querbereich aufweist. Dadurch lässt sich die Kühlflüssigkeit in dem U-Förmigen Kühlkanal möglichst nah an die Keramikschicht des Metall-Keramik-Substrats führen und das Kühlsubstrat wird gleichmäßig gekühlt. Insbesondere ist es vorgesehen, dass der Querbereich bogenförmig ausgestaltet ist und/oder in Stapelrichtung gesehen den Umkehrpunkt des Fluids bildet. Insbesondere ist es vorgesehen, dass sich der Fluidkanal in Stapelrichtung gesehen über mehr als die Hälfte, bevorzugt mehr als zwei Dritte und besonders bevorzugt zu mehr als drei Viertel der gesamten in Stapelrichtung bemessenen Dicke der Kühlstruktur erstreckt. Weiterhin ist es vorgesehen, dass sich in Stapelrichtung gesehen (in verbauten Zustand der Bauteilseite zugewandt) an den Querbereich ein einlagige Metallschicht, insbesondere Kupferschicht, anschließt. Dabei weist diese einlagige Metallabschlussschicht eine Dicke zwischen 0,2 und 1,5 mm, bevorzugt zwischen 0,4 und 1 und besonders bevorzugt zwischen 0,6 mm und 0,8 mm auf.

Gemäß einer weiteren Ausführungsform der vorliegenden Erfindung ist es vorgesehen, dass sich ein parallel zur Haupterstreckungsebene verlaufender Öffnungsquerschnitt der Schenkelbereiche entlang einer Strömungsrichtung innerhalb der Kühlstruktur seitlich verlagert, insbesondere umfasst der Schenkelbereich einen ersten Teilabschnitt mit einem ersten Öffnungsquerschnitt und einen zweiten Teilabschnitt mit einem zweiten Öffnungsquerschnitt, wobei der erste Öffnungsquerschnitt zum zweiten Öffnungsquerschnitt in einer parallel zur Haupterstreckungsebene verlaufenden Richtung gesehen um einen Versatzabstand versetzt ist. Bevorzugt weist der Versatz einen Wert zwischen 50 µm und 500 µm, bevorzugt zwischen 80 µm und 300 µm und besonderes bevorzugt zwischen 100 µm und 200 µm. Dabei ist es insbesondere vorgesehen, dass innerhalb des ersten Teilbereichs und innerhalb des zweiten Teilbereich der Öffnungsquerschnitt nicht verlagert ist (d. h. der Öffnungsquerschnitt ist in Stapelrichtung gesehen konstant), so dass sich ein diskreter Sprung zwischen dem ersten Öffnungsquerschnitt und dem zweiten Öffnungsquerschnitt einstellt. Der erste Teilbereich und der zweite Teilbereich legen dabei einzelne Schichtebene fest, die beispielsweise entsprechenden Metalllagen zuzuordnen sind, wenn die Kühlstruktur beispielsweise durch ein Aufeinanderschichten verschiedener Metalllagen gebildet wurde. Die Metalllagen haben eine in Stapelrichtung gemessene Dicke zwischen 100 µm und 1000 µm, vorzugsweise zwischen 200 µm und 800 µm und besonders bevorzugt zwischen 500 µm und 600 µm. Bei solchen Dicken lässt sich der Ätzprozess (zum Einbringen von Aussparungen, die im gefertigten Zustand die Öffnungsquerschnitte bilden) verbessert kontrollieren, und es haben sich diese Dicken ebenfalls als vorteilhaft für die Kühlperformance erwiesen.

Durch den Versatz des ersten Öffnungsquerschnitts zum zweiten Öffnungsquerschnitt lassen sich insbesondere an den Übergängen zwischen dem ersten Teilabschnitt und dem zweiten Teilabschnitt Kanten bzw. Rücksprünge erzeugen, die zur Wirbelbildung in der Strömung innerhalb des Fluidkanals führen, die sich wiederum positiv auf den Wärmeabtransport über die Kühlstruktur auswirken. Es ist auch vorstellbar, dass die Verwirbelungen innerhalb des Fluidkanals durch in den Fluidkanal hineinragende Strukturen realisiert werden.

In einer weiteren Ausführungsform der vorliegenden Erfindung ist es vorgesehen, dass zumindest einer der Schenkelbereiche zur Verwirbelung des Fluid zumindest bereichsweise einen im Wesentlichen spiralförmigen Verlauf aufweist. Der spiralförmige Verlauf zeichnet sich insbesondere dadurch aus, dass sich ein parallel zur Haupterstreckungsebene verlaufender Öffnungsquerschnitt der Schenkelbereiche entlang einer Strömungsrichtung innerhalb der Kühlstruktur zumindest in zwei verschiedene in der Haupterstreckungsebene liegende Richtungen nacheinander seitlich verlagert. Bevorzugt erfolgt der Versatz über mehrere Ebene im oder entgegen dem Uhrzeigersinn. Durch den spiralförmigen Versatz wird insbesondere ein Kontaktfläche zwischen dem Fluid und der metallischen Kühlstruktur vergrößert, was sich ebenfalls positiv auf den Wärmabtransport und somit die Kühlperformance auswirkt.

Gemäß einer weiteren Ausführungsform der vorliegenden Erfindung ist es vorgesehen, dass die Verteilstruktur eine an der Kühlstruktur anliegende wandartige Struktur aufweist, wobei die wandartige Struktur gegenüber der Reihenrichtung um weniger als 15° geneigt ist, vorzugsweise parallel zur Reihenrichtung verläuft. Insbesondere ist es vorgesehen, dass mittels der wandartigen Struktur das andernfalls entlang der Hauptströmungsrichtung geführte Fluid zur Seite, d. h. quer zur ersten Hauptströmungsrichtung, umgelenkt wird, um es jeweils den einzelnen Eingangsöffnungen bereitzustellen. Vorzugsweise werden sowohl der einleitenden Teil als auch der ausleitende Teil jeweils als wandartige Struktur ausgebildet.

In einer weiteren Ausführungsform der vorliegenden Erfindung ist es vorgesehen, dass die Verteilstruktur zwei benachbarte Reihen von Eingangsöffnungen mit dem Fluid versorgt. Insbesondere sind hier der einleitende Teil und der ausleitende Teil jeweils als Kanal mit einem Boden und zwei den Kanal seitlich begrenzenden Seiten ausgebildet, wobei sich eine Längsrichtung der Kanäle im Wesentlichen parallel zur Reihenrichtung erstreckt. Der als Kanal ausgebildete einleitende Teil ist zur Außenseite der Kühlstruktur offen und derart dimensioniert bzw. ausgerichtet, dass er in Stapelrichtung gesehen nicht unterhalb einer Reihe von Fluidkanälen angeordnet ist, sondern jeweils unter einer Hälfte von zwei benachbarten Reihen von Fluidkanälen. Entsprechend bilden in dieser Ausführungsform zwei in einer senkrecht zur Reihenrichtung verlaufenden Richtung benachbarte Eingangsöffnungen zweier verschiedener Fluidkanäle bzw. zwei Ausgangsöffnungen zweier verschiedener Ausgangsöffnungen jeweils ein Paar. Jedem dieser Paare, die selbst wieder in Reihenrichtung eine Reihe bilden, ist wiederum ein einleitender Teil oder ein ausleitender Teil als Kanal zugeordnet. Im Gegensatz zu einer Verteilstruktur, bei der eine wandartige Struktur das Fluid seitlich verlagert, sorgt hier der Fluidkanal für eine seitliche Verlagerung. Mit anderen Worten: Das Fluid wird von einem Kanal, dem einleitenden Teil, in einen benachbarten Kanal, den ausleitenden Teil, über den Fluidkanal umgelenkt bzw. umverteilt. Vorzugsweise bildet der Boden des einleitenden Teils eine rampenförmige Struktur die in erster Hauptströmungsrichtung in Richtung der Außenseite der Kühlstruktur geneigt ist. Insbesondere ist der Boden des ausleitenden Teils, d. h. der benachbarten Verteilstruktur entgegengesetzt geneigt, um einen Abfluss des Fluid über den ausleitenden Teil, d. h. den benachbarten Kanal, zu begünstigen. Mit anderen Worten: Die Neigung der rampenförmigen Böden in den benachbarten Kanälen, die jeweils einen einleitenden Teil und einen ausleitenden Teil bilden, sind entgegengesetzt zueinander geneigt.

Ein weiterer Gegenstand der vorliegenden Erfindung ist ein Metall-Keramik-Substrat mit einer Bauteilseite und einer der Bauteilseite gegenüberliegenden Kühlseite, wobei das Metall-Keramik-Substrate eine sich entlang der Haupterstreckungsebene erstreckende Keramikschicht und Metallisierungsschicht aufweist, wobei die Kühlseite
- eine metallische Kühlstruktur mit mindestens einem integriertem Fluidkanal zur Führung eines Fluid und
- eine Verteilstruktur aus Kunststoff zur Versorgung des Fluidkanals mit dem Fluid,
wobei die Kühlstruktur an seiner der Verteilstruktur zugewandten Außenseite eine Eingangsöffnung und eine von der Eingangsöffnung separate Ausgangsöffnung aufweist, wobei die Eingangsöffnung und die Ausgangsöffnung über den Fluidkanal miteinander verbunden sind und der Fluidkanal derart gestaltet ist, dass das Fluid in der verbauten Kühlstruktur von der Eingangsöffnung in Richtung der Bauteilseite geführt und innerhalb der Kühlstruktur umgelenkt wird. Alle für das erfindungsgemäße System beschriebenen Merkmale und deren Vorteile lassen sich sinngemäß ebenfalls auf das erfindungsgemäße System übertragen und andersherum.

Besonders bevorzugt ist es vorgesehen, wenn das Metall-Keramiksubstrat neben einer Keramikschicht eine Sekundärschicht aufweist, und zwischen der Keramikschicht und der Sekundärschicht eine metallische Zwischenschicht angeordnet ist, wobei die metallische Zwischenschicht in Stapelrichtung gesehen dicker ist als die Dicke der Keramikschicht, die Dicke der Sekundärschicht und/oder die Summe aus den Dicken der Keramikschicht und der Sekundärschicht. Vorzugsweise ist die metallische Zwischenschicht für eine optimale Wärmespreizung dicker als 1 mm, bevorzugt dicker als 1,5 mm und besonders bevorzugt dicker als 2,5 mm und/oder die metallische Zwischenschicht ist einlagig ausgebildet.

Weiterhin ist es bevorzugt vorgesehen, dass die Kühlstruktur integraler Bestandteil des Metall-Keramik-Substrats ist. Hierzu ist die Kühlstruktur vorzugsweise mittels eines DCB (direct copper bonding)-Verfahrens, eines DAB (direct aluminium bon-ding)-Verfahrens und/oder eines AMB (active metal brazing)-Verfahrensan die Keramikschicht und/oder die Sekundärschicht angebunden.
Ein weiterer Gegenstand der vorliegenden Erfindung ist ein Verfahren zur Herstellung eines erfindungsgemäßen Systems, wobei die Kühlstruktur mit dem mindestens einen Fluidkanal durch einen Schichtaufbau und/oder durch ein 3D - Druckverfahren hergestellt wird. Alle für das erfindungsgemäße System bzw. das Metall-Keramik-Substrat beschriebenen Merkmale und deren Vorteile lassen sich sinngemäß ebenfalls auf das erfindungsgemäße Verfahren übertragen und andersherum.

Im Falle der Fertigung des Fluidkanals mittels eines Schichtaufbaus ist es bevorzugt vorgesehen, dass in die einzelnen Metalllagen Aussparungen eingestanzt und/oder eingeätzt werden und anschließend die einzelnen Schichten so entlang der Stapelrichtung übereinander angeordnet werden, dass sich der Fluidkanal ausbildet. Hierzu werden die einzelnen Aussparungen, die im fertigen Zustand den ersten bzw. den zweiten Öffnungsquerschnitt festlegen, entsprechend ausgerichtet. Insbesondere ist in einer der Metalllagen statt zweier Aussparungen ein Langloch ausgebildet, beispielsweise eingestanzt oder geätzt. Dieses Langloch bildet in der späteren zusammengesetzten Kühlstruktur den Querbereich, in dem das Fluid umgelenkt wird. Die einzelnen Metalllagen können aus unterschiedlichen Metallen ausgebildet sein bzw. unterschiedliche Dicken aufweisen. Insbesondere ist es vorstellbar, dass sich die Metallschichten mit den Aussparungen zur Bildung des Fluidkanals von denen unterscheiden, in denen keine Aussparungen eingelassen sind und die im zusammengesetzten Zustand zwischen dem Querbereich des Fluidkanals und der Keramikschicht bzw. der Sekundärschicht angeordnet sind.

Als Materialien für die Metallisierungsschicht, die Zwischenschicht, die Kühlstruktur und/oder eine Schicht der Kühlstruktur sind Kupfer, Aluminium, Molybdän und/oder deren Legierungen, sowie Laminate wie CuW, CuMo, CuAl, AICu und/oder CuCu, insbesondere eine Kupfersandwichstruktur mit einer ersten Kupferschicht und einer zweiten Kupferschicht, wobei sich eine Korngröße in der ersten Kupferschicht von einer zweiten Kupferschicht unterscheidet, vorstellbar. Weiterhin ist es bevorzugt vorgesehen, dass die Metallisierungsschicht oberflächenmodifiziert ist. Als Oberflächenmodifikation ist beispielsweise eine Versiegelung mit einem Edelmetall, insbesondere Silber und/oder Gold, oder ENIG ("Electroless nickel immersion gold") oder ein Kantenverguss an der ersten bzw. zweiten Metallisierungsschicht zur Unterdrückung einer Rissbildung bzw. -weitung denkbar. Vorzugsweise ist es vorgesehen, dass die Metalllagen untereinander zur Bildung der Kühlstruktur durch ein DCB-Verfahren und/oder Lötverfahren miteinander verbunden sind. Beispielsweise werden die Metalllagen aufeinandergelegt und anschließend gelötet und/oder gesintert.

Vorzugsweise weist die Keramikschicht Al₂O₃, Si₃N₄, AIN, eine HPSX-Keramik (d. h. eine Keramik mit einer Al₂O₃- Matrix, die einen x-prozentigen Anteil an ZrO₂ umfasst, beispielsweise Al₂O₃ mit 9% Zr_{O2} = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) oder ZTA als Material für die Keramik auf. Es ist dabei auch vorstellbar, dass die Isolationsschicht als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einer Isolationsschicht zusammengefügt sind. Vorzugsweise wird eine hochwärmeleitfähige Keramik für einen möglichst geringen Wärmwiderstand verwendet.

In einer bevorzugten Ausführungsform der vorliegenden Erfindung ist es vorgesehen, dass das Metall-Keramik-Substrat mit der Kühlstruktur und/oder der Verteilstruktur thermomechanisch symmetrisch ausgestaltet ist, insbesondere entlang einer Stapelrichtung, die senkrecht zu einer Haupterstreckungsebene des Trägersubstrats verläuft. Unter einer thermomechanische symmetrischen Ausbildung ist insbesondere zu verstehen, dass thermomechanische Ausdehnungskoeffizienten in Stapelrichtung gesehen symmetrisch sind. Der thermomechanische Ausdehnungskoeffizient ist dabei ein Maß für die Ausdehnung der jeweiligen Schicht bei einem Temperaturwechsel bzw. einer Temperaturänderung. Vorzugsweise lässt sich Metall-Keramiksubstrat in virtuelle Teilsubstrate unterteilen, insbesondere mit einem virtuellen Primärsubstrat, einem virtuellen Sekundärsubstrat und einer virtuellen Zwischenschicht und die thermischen Ausdehnungskoeffizienten der virtuellen Teilsubstrate sind symmetrisch in Stapelrichtung verteilt. Insbesondere berücksichtigt das Sekundärsubstrat die Kühlstruktur und/oder die Verteilstruktur, wobei im Falle der Kühlstruktur eine thermomechanisch effektive Dicke für die Kühlstruktur angenommen wird, die die Existenz der Fluidkanäle in der Kühlstruktur berücksichtigt.

Durch die symmetrische Gestaltung der Ausdehnungskoeffizienten wird in vorteilhafter Weise ein Metall-Keramik-Substrat bereitgestellt, das vergleichsweise verwindungsarm ist gegenüber betriebsbedingten bzw. umgebungsbedingten Temperaturwechseln. Infolgedessen lassen sich Defekte bzw. Risse vermeiden, die andernfalls durch thermisch induzierte mechanische Spannungen veranlasst werden würden.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsformen können dabei im Rahmen der Erfindung miteinander kombiniert werden.

Es zeigt:
- **Fig.1:**: schematische Darstellung eines Metall-Keramik-Substrats gemäß einer ersten beispielhaften Ausführungsform der vorliegenden Erfindung
- **Fig.2 bis Fig.6:**: detaillierte Darstellung des Systems aus Kühlstruktur und Verteilstruktur der ersten beispielhaften Ausführungsform der vorliegenden Erfindung;
- **Fig. 7:**: schematische Darstellung eines Systems aus Kühlstruktur und Verteilstruktur gemäß einer zweiten beispielhaften Ausführungsform der vorliegenden Erfindung
- **Fig. 8:**: perspektivische Darstellung des Systems aus Figur 7 und
- **Fig. 9:**: perspektivische Darstellung der Verteilstruktur aus Figur 8.

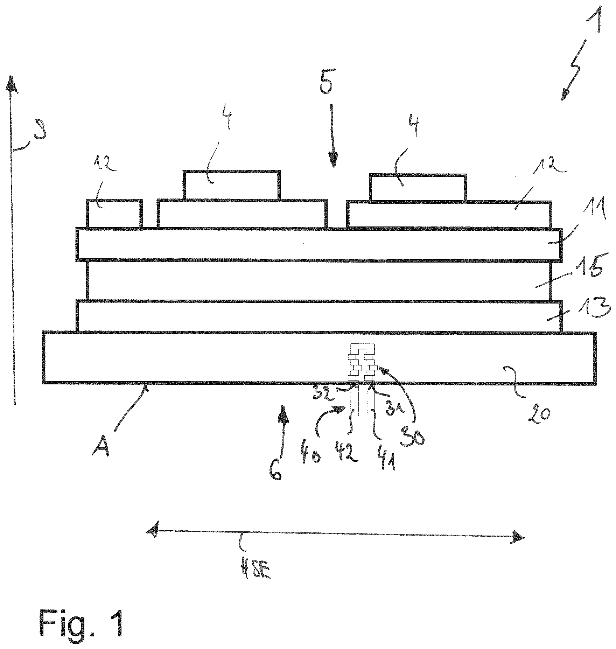

In **Figur 1** ist schematisch ein Metall-Keramik-Substrat 1 gemäß einer ersten beispielhaften Ausführungsform der vorliegenden Erfindung dargestellt. Solche Metall-Keramik-Substrate 1 dienen vorzugsweise als Träger von elektronischen bzw. elektrischen Bauteile 4, die an das Metall-Keramik-Substrat 1 anbindbar sind. Wesentliche Bestandteile eines solchen Metall-Keramik-Substrats 1 sind eine sich entlang einer Haupterstreckungsebene HSE erstreckende Keramikschicht 11 und eine an der Keramikschicht 11 angebundene Metallschicht 12. Die Keramikschicht 11 ist aus mindestens einem eine Keramik umfassenden Material gefertigt. Die Metallschicht 12 und die Keramikschicht 11 sind dabei entlang einer senkrecht zur Haupterstreckungsebene HSE verlaufenden Stapelrichtung S übereinander angeordnet und über eine Anbindungsfläche miteinander stoffschlüssig verbunden. Im gefertigten Zustand ist die Metallschicht 12 auf einer Bauteilseite 5 des Metall-Keramik-Substrats 1 zur Bildung von Leiterbahnen oder Anbindungsstellen für die elektrischen Bauteile strukturiert. In der dargestellten Ausführungsform umfasst das Metall-Keramik-Substrat 1 eine Sekundärschicht 13 und eine zwischen der Keramikschicht 11 und der Sekundärschicht 13 angeordnete metallische Zwischenschicht 15. Die Keramikschicht 11, die metallische Zwischenschicht 15 und die Sekundärschicht 13 sind entlang der Stapelrichtung S übereinander angeordnet. Ferner ist es vorgesehen, dass die metallische Zwischenschicht 15 dicker ist als die Keramikschicht 11 und/oder die Sekundärschicht 13. Vorzugsweise ist die metallische Zwischenschicht 15 dicker als 1 mm, bevorzugt dicker als 1,5 mm und besonders bevorzugt dicker als 2,5 mm. Während die Keramikschicht 11 bevorzugt aus Keramik ist und zur Ausbildung einer ausreichenden Isolationsfestigkeit und zur Versteifung des Metall-Keramik-Substrats 1 ausgelegt ist, kann die Sekundärschicht 13 beispielsweise auch aus Wolfram oder Molybdän sein, da hier keine ausgeprägte Isolationsfestigkeit erforderlich ist. So lassen sich die Materialkosten senken. Alternativ ist die Sekundärschicht 13 ebenfalls aus einem eine Keramik umfassenden Material gefertigt.

Auf einer der Bauteilseite 5 gegenüberliegenden Kühlseite 6 des Metall-Keramik Substrats 1 ist eine metallische Kühlstruktur 20 vorgesehen. Die metallische Kühlstruktur 20 ist vorzugsweise unmittelbar an die Sekundärschicht 13 angebunden. Dadurch lässt sich vermeiden, dass eine sich andernfalls ausbildende Grenzfläche mit einem entsprechenden Verbindungsmaterial negativ auf die Wärmleitfähigkeit und somit einschränkend auf einen Wärmeabtransport von der Bauteilseite 5 zur Kühlseite 6 auswirkt. Beispielsweise ist die Kühlstruktur 20 über ein AMB-Verfahren, ein DCB (direct copper bonding)- oder DAB (direct aluminium bonding)-Verfahren unmittelbar an die Sekundärschicht 13 angebunden. Insbesondere ist es vorgesehen, dass in die metallische Kühlstruktur 20 eine Vielzahl von Fluidkanälen 30 integriert ist. Der Übersicht halber ist in Figur 1 beispielhaft nur ein einzelner dieser Fluidkanäle 30 eingezeichnet. Die Fluidkanäle 30 dienen einer gezielten Führung eines Fluids, insbesondere eines Kühlfluids, innerhalb der metallischen Kühlstruktur 20. Der Kühlstruktur 20 wird das Fluid über ein Verteilstruktur 40 zugeführt und über die Verteilstruktur 40 wieder abgeführt. Vorzugsweise weist die Verteilstruktur 40 hierzu einen einleitenden Teil 41 und einen ableitenden Teil 42 auf.

Insbesondere weist der Fluidkanal 30 eine Eingangsöffnung 31 und eine von der Eingangsöffnung 31 beabstandete Ausgangsöffnung 32 auf. Dabei sind die Eingangsöffnung 31 und die Ausgangsöffnung 32 Teil einer der Verteilstruktur 40 zugewandten Außenseite A der Kühlstruktur 20. Insbesondere grenzt der einleitende Teil 31 der Verteilstruktur 40 an die Eingangsöffnung 31 und der ableitenden Teil 42 an die Ausgangsöffnung 32 an.

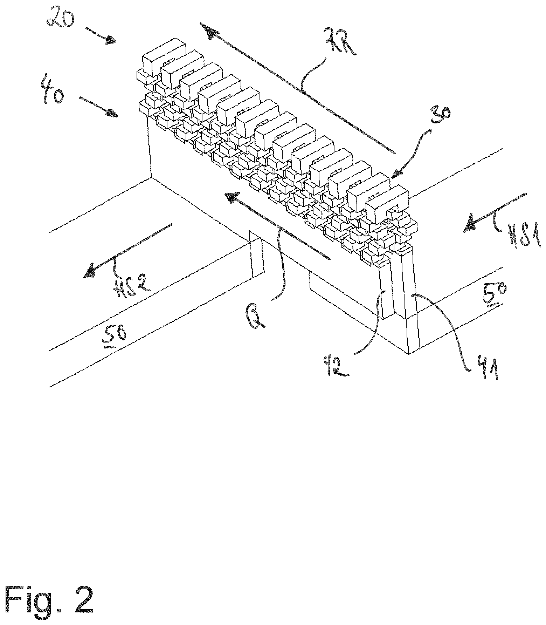

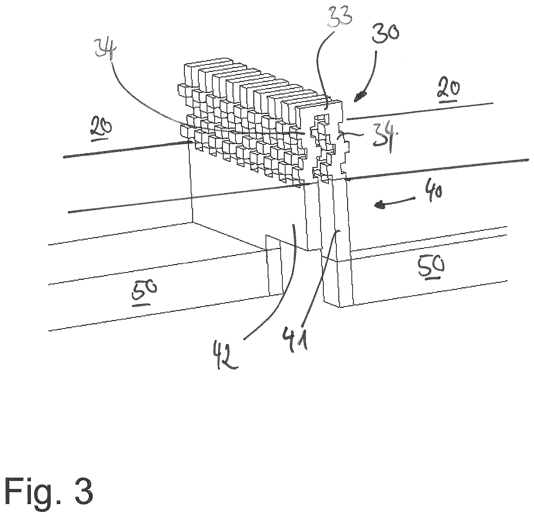

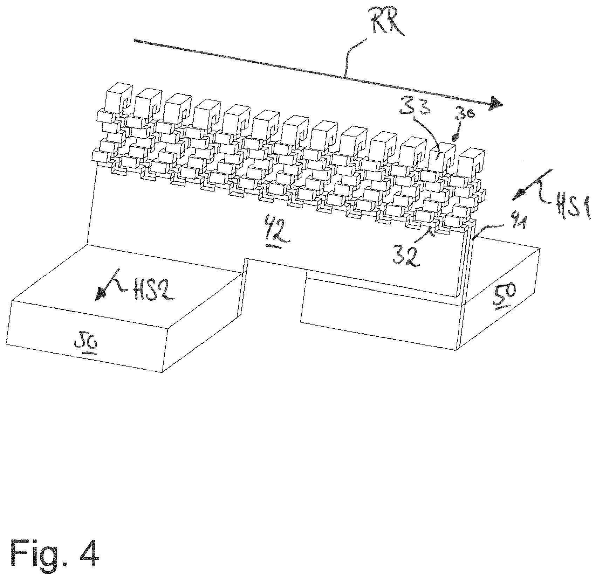

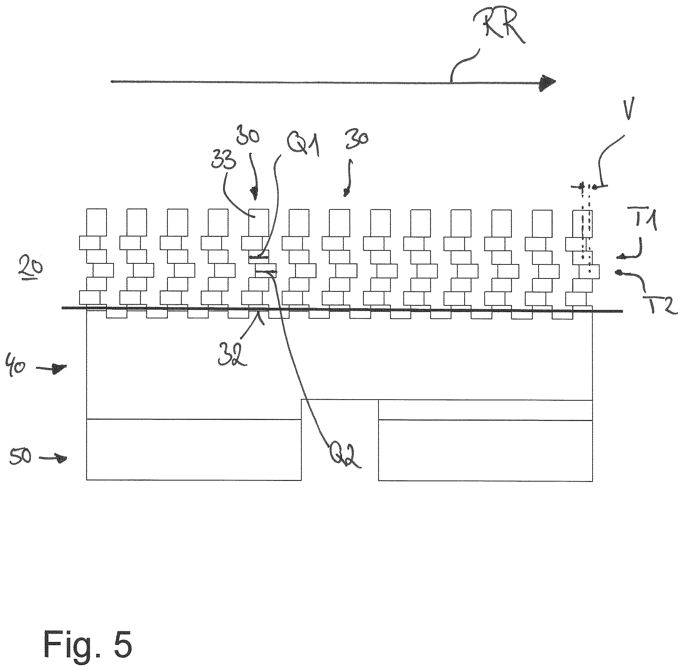

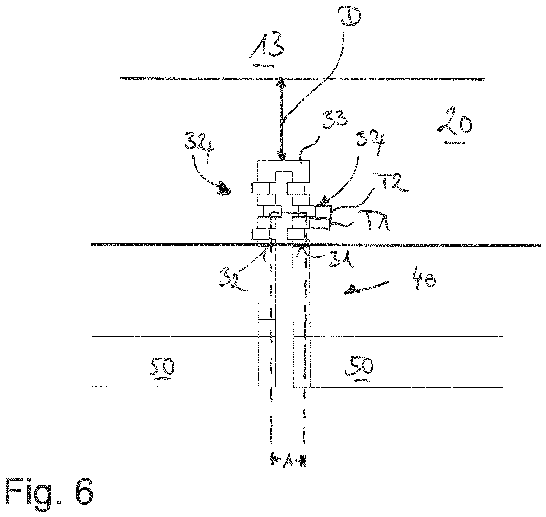

In den Figuren 2 bis 4 sind jeweils nur die metallische Kühlstruktur 20 und die Verteilstruktur 40 in perspektivischen Darstellungen und in den Figuren 5 und 6 in zwei verschiedenen Seitenansichten dargestellt. Dabei sind in den Figuren - statt der gesamten Kühlstruktur 20 - die mehreren Fluidkanäle 30 der Kühlstruktur 20 dargestellt. Mit anderen Worten: Hier sind die Fluidkanäle 30 ohne den metallischen Körper dargestellt, in den sie eingelassen sind. In Stapelrichtung S gesehen schließt ferner an der Unterseite der Verteilstruktur 40 eine Zuführstruktur 50 an. Demnach ist in Stapelrichtung S gesehen, die Verteilstruktur zwischen der Kühlstruktur und der Zuführstruktur angeordnet. Solch eine Zuführstruktur 50 ist vorzugsweise dazu vorgesehen, eine erste Hauptströmungsrichtung HS1 vorzugeben. Beispielsweise ist die Zuführstruktur kanalförmig ausgebildet. Ferner umfasst die Zuführstruktur 50 mindestens einen Einlass und einen Auslass (hier nicht dargestellt) an die ein Fluidkreislauf angeschlossen werden kann bzw. eine Kühlfluidversorgung und eine Kühlfluidentsorgung. Die Verteilstruktur 40 ist dabei vorzugsweise derart ausgestaltet, dass sie das Fluid aus einem entlang der ersten Hauptströmungsrichtung HS1 fließende Strom heraus in die Kühlstruktur 20 umlenkt bzw. dort einleitet. Weiterhin zeigen die Figuren 2 bis 5 der Übersicht halber lediglich ein einzelne Reihe Fluidkanälen 30. Bevorzugt ist es vorgesehen, dass mehrere Reihen in einer senkrecht zur Reihenrichtung RR und parallel zur Haupterstreckungsebene HSE verlaufenden Richtung nebeneinander bzw. hintereinander angeordnet sind und jede dieser Reihen wird über eine entsprechende Verteilstruktur 40, beispielswiese eine einzelne Verteilstruktur, mit dem Fluid versorgt. Vorzugsweise erstrecken sich diese mehrere Reihen vollständig über die der Verteilstruktur zugewandten Außenseite A der Kühlstruktur 20.

Insbesondere ist es vorgesehen, dass mehrere Fluidkanäle 30 nebeneinander angeordnet sind. Insbesondere sind in der dargestellten Ausführungsform die Fluidkanäle 30 entlang einer Reihe angeordnet, die im dargestellten Ausführungsbeispiel im Wesentlichen senkrecht zur ersten Hauptströmungsrichtung HS1 verläuft. Grundsätzlich ist es auch vorstellbar, dass die Reihe entlang einer Reihenrichtung RR verläuft, die gegenüber der ersten Hauptströmungsrichtung HS1 um einen Winkel zwischen 0 und 90° geneigt ist. Vorzugsweise ist der Winkel kleiner 45°.

In dem in den Figuren 2 bis 6 dargestellten Ausführungsbeispiel ist es vorgesehen, dass die Verteilstruktur 40 das Fluid so umlenkt, dass zumindest ein Teil des Fluid zunächst von einer ersten Hauptströmungsrichtung HS1 in eine parallel zur Reihenrichtung verlaufende Querrichtung Q umgelenkt wird, bevor es in die Eingangsöffnungen 31 geleitet wird. Zusätzlich wird das Fluid in Richtung der Eingangsöffnung 31 in Richtung der Kühlstruktur 20, d. h. nach oben, umgelenkt. Dadurch kann die Verteilstruktur mehrere Eingangsöffnungen 31 verschiedener Fluidkanäle 30 mit einem gleichtemperierten Fluid versorgen. Hierzu ist der einleitende Teil 41 als wandartige Struktur ausgebildet, die im dargestellten Ausführungsbeispiel im Wesentlichen parallel zur Reihenrichtung RR verläuft. Bevorzugt ist es vorgesehen, dass die Zuführstruktur 50 das Fluid nur einem Teil der Verteilstruktur 40 zuführt. Im dargestellten Ausführungsbeispiel wird entlang der ersten Hauptströmungsrichtung HS1 gesehen im Wesentlichen ein erster Teil, insbesondere eine linke Hälfte, des einleitenden Teils 41 durch das Kühlfluid angeströmt. Mittels der Verteilstruktur 40 wird aber die vollständige Reihe von Fluidkanälen 30 mit dem Fluid versorgt. Vorzugsweise umfasst der einleitenden Teil eine rampenartige Struktur, die in Reihenrichtung RR gesehen geneigt ist, insbesondere gegenüber der Haupterstreckungsebene HSE geneigt ist.

Nach dem Durchtritt durch die Fluidkanäle 30 verlässt das Fluid die Kühlstruktur 20 über die Ausgangsöffnungen 32 und wird in den ausleitenden Teil 42 der Verteilstruktur geführt. Der ausleitende Teil 42 der Verteilstruktur 40 ist ebenfalls als wandartige Struktur ausgestaltet, die im Wesentlichen parallel zur Reihenrichtung RR verläuft. Insbesondere ist es vorgesehen, dass der ausleitenden Teil 42 so gestaltet ist, dass er das aus den Ausgangsöffnungen 42 tretenden Fluid sammelt und in eine zweite Hauptströmungsrichtung HS2 zurück in die Zuführstruktur 50 umlenkt. Beispielsweise umfasst der ausleitende Teil 42 eine rampenartige Struktur die in Reihenrichtung RR geneigt ist, insbesondere entgegengesetzt geneigt zur rampenartigen Struktur im einleitenden Teil 41 der Verteilstruktur 40. Ferner ist es vorgesehen, dass die erste Hauptströmungsrichtung HS1 und die zweite Hauptströmungsrichtung HS2 parallel zueinander versetzt sind. Mit anderen Worten: Nach dem Verlassen der Verteilstruktur 40 ist die Strömung des Fluid seitlich bzw. lateral versetzt gegenüber der Strömung beim Anströmen der Verteilstruktur 40.

In der dargestellten Ausführungsform ist der einleitenden Teil 41 der Verteilstruktur 40 entlang der ersten Hauptströmungsrichtung HS1 gesehen vor dem ausleitenden Teil 42 der Verteilstruktur 40 angeordnet. Es ist aber auch vorstellbar, dass der ausleitende Teil 42 entlang der ersten Hauptströmungsrichtung HS1 gesehen vor dem einleitenden Teil 31 der Verteilstruktur 40 angeordnet ist.

Die einzelnen Fluidkanäle 30 sind bevorzugt U-Förmig gestaltet, wobei der U-förmig gestaltete Fluidkanal 30 zwei im Wesentlichen senkrecht zur Haupterstreckungsebene HSE verlaufende Schenkelbereiche 34 und einen die beiden Schenkelbereiche 34 verbindenden Querbereich 33 aufweist. Insbesondere dient der Querbereich 33 dem Umlenken des Fluid und ist im verbauten Zustand der Sekundärschicht 13 bzw. der Keramikschicht 11 am nächsten. Vorzugsweise nimmt eine Distanz zwischen dem Querbereich 33 und einer an die Kühlstruktur 20 angrenzende Keramikschicht 11 bzw. Sekundärschicht 13 einen Wert zwischen 0,2 und 1,5 mm, bevorzugt zwischen 0,4 und 1 und besonders bevorzugt zwischen 0,6 mm und 0,8 mm an. Vorzugsweise sind die Fluidkanäle 30, insbesondere deren Schenkelbereiche 34 so gestaltet, dass das Fluid innerhalb der Fluidkanäle 30 verwirbelt wird. Hierzu ist es beispielsweise vorgesehen, dass sich ein parallel zur Haupterstreckungsebene HSE verlaufender Öffnungsquerschnitt Q1, Q2 der Schenkelbereiche 34 entlang einer Strömungsrichtung des Fluid innerhalb des Fluidkanals 30, insbesondere innerhalb des Schenkelbereichs 34, seitlich verlagert. Dabei umfasst der Schenkelbereich 34 einen ersten Teilabschnitt T1 mit einem ersten Öffnungsquerschnitt Q1 und einen zweiten Teilabschnitt T2 mit einem zweiten Öffnungsquerschnitt Q2, wobei der erste Öffnungsquerschnitt Q1 zum zweiten Öffnungsquerschnitt Q2 in einer parallel zur Haupterstreckungsebene HSE verlaufenden Richtung gesehen um einen Versatzabstand V versetzt ist. Vorzugsweise sind der ersten Öffnungsquerschnitt Q1 und der zweite Öffnungsquerschnitt Q2 gleich groß. Es ist aber auch vorstellbar, dass sich der erste Öffnungsquerschnitt vom zweiten Öffnungsquerschnitt unterscheidet. Insbesondere sind der erste Teilabschnitt T1 und der zweite Teilabschnitt T2 jeweils Metalllagen zugeordnet, die beispielsweise bei der Fertigung übereinandergestapelt werden. Dabei können die einzelnen Metalllagen gleich dick sein oder sich bezüglich ihrer Dicke unterscheiden. Es ist beispielsweise auch vorstellbar, dass die Dicke der einzelnen Ebenen in Richtung der Bauteilseite ab- und/oder zunimmt.

Insbesondere ist es vorgesehen, dass der erste Öffnungsquerschnitt Q1 und der zweite Öffnungsquerschnitt Q2 in einer parallel zur ersten Hauptströmungsrichtung HS1 bzw. zweiten Hauptströmungsrichtung HS2 und einer parallel zur Reihenrichtung RR, d. h. in zwei zueinander nicht parallel verlaufenden Richtungen, zueinander versetzt sind. Vorzugsweise nimmt ein Verhältnis eines Überlappbereichs, in dem der ersten Öffnungsquerschnitt Q1 und der zweite Öffnungsquerschnitt Q2 in Stapelrichtung S gesehen übereinander angeordnet sind, und dem ersten Öffnungsquerschnitt Q1 bzw. dem zweiten Öffnungsquerschnitt Q2 einen Wert zwischen 0,5 und 0,9, bevorzugt zwischen 0,5 und 0,8 und besonders bevorzugt zwischen 0,5 und 0,7 an. Vorstellbar ist insbesondere dass der Öffnungsquerschnitt der Eingangsöffnung und/oder der Ausgangsöffnung größer ist als der erste Öffnungsquerschnitt und/oder der zweite Öffnungsquerschnitt. Dadurch lässt sich ein trichterartiger Eingangsbereich und Ausgansbereich für den Fluidkanal bilden.

Es ist aber auch vorstellbar, dass der erste Öffnungsquerschnitt Q1 und der zweite Öffnungsquerschnitt Q2 unterschiedlich groß sind. Bevorzugst sind erste und zweite Öffnungsquerschnitte derart ausgestaltet, dass sie einen im Wesentlichen spiralförmigen Verlauf für den Fluidkanal 30 bilden. Die Fluidkanäle 30 lassen sich beispielsweise durch ein Aufeinanderschichten von Metalllagen mit entsprechenden Öffnungen oder durch ein 3D Druckverfahren realisieren. Weiterhin ist es vorgesehen, dass die Eingangsöffnung 13 einen ersten Öffnungsquerschnitt aufweist, dessen Durchmesser und/oder Kantenlänge einen Wert zwischen 0,1 mm und 2,5 mm, bevorzugt zwischen 0,5 mm und 1,5 mm und bevorzugt im Wesentlichen von 1 mm aufweist. Dabei ist es bevorzugt vorgesehen, dass sich der erste Öffnungsquerschnitt Q1 bzw. der zweite Öffnungsquerschnitt Q2 innerhalb der Schenkelbereiche 34 des Fluidkanals 30 nicht ändern.

Weiterhin ist es vorgesehen, dass ein Abstand A zwischen zweier benachbarter Schenkelbereiche, bevorzugt desselben Fluidkanals, einen Wert zwischen 0,1 mm und 5 mm, bevorzugt zwischen 0,2 mm und 2 mm und besonders bevorzugt im Wesentlichen 1,5 mm annimmt. Dabei wird der Abstand A zwischen zwei Mitten der ersten Querschnittsöffnung Q1 bzw. zweiten Querschnittsöffnungen Q2 auf derselben Höhe in Stapelrichtung S gesehen gemessen.

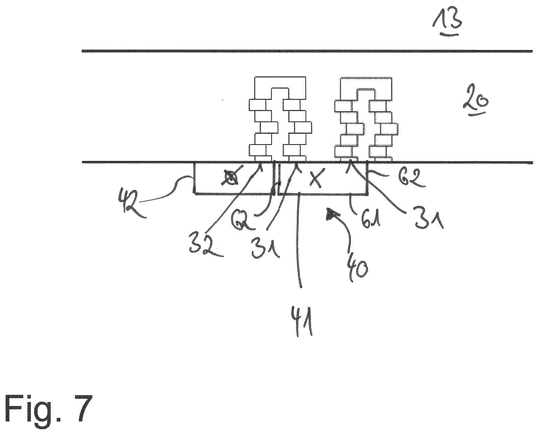

In der Figur 7 ist eine Anordnung von Kühlstruktur 20 und Verteilstruktur 40 gemäß einer weiteren Ausführungsform der vorliegenden Erfindung dargestellt. Dabei unterscheidet sich diese Ausführungsform im Wesentlichen in Hinblick auf das Einleiten des Fluid in den Fluidkanal 30. Insbesondere ist es vorgesehen, dass er einleitende Teil und der ausleitenden Teil im Wesentlichen schalen- bzw. kanalförmig ausgestaltet ist, wobei die schalförmige Struktur zur Außenseite A der Kühlstruktur 20 hin offen ist und an dieser unmittelbar angrenzt. In der dargestellten Ausführungsform umfasst das Schalenelement insbesondere einen Boden 61 und zwei senkrecht vom Boden 61 abstehende Seiten 62. Weiterhin ist es vorgesehen, dass das Schalenelement sich im Wesentlichen parallel zur Reihenrichtung RR längserstreckt, so dass das Schalenelement das Fluid entlang der Außenseite der Kühlstruktur 20 in eine Richtung leitet, die beispielsweise in die Zeichenebene hineinragt (angedeutet durch x). Insbesondere ist es vorgesehen, dass das Schalenelement entlang der Haupterstreckungsebene HSE derart dimensioniert ist, dass das Schalenelement Eingangsöffnungen 31 zweier Fluidkanäle versorgt, die in benachbarten Reihen angeordnet sind. Mit anderen Worten: in der Ausführungsform der Figur 7 teilen sich die Eingangsöffnungen 31 der Fluidkanäle 30 in benachbarten Reihen einen einleitenden Teil 41 und sind hierzu zueinander benachbart angeordnet. D. h. in einer senkrecht zur Reihenrichtung RR verlaufenden Richtung wechseln sich die Eingangsöffnungen 31 und Ausgangsöffnungen 32 für die Fluidkanäle nicht ab, sondern bilden jeweils Paare, die abwechselnd jeweils dem einleitenden Teil 41 und dem ausleitenden Teil 42 zugeordnet sind. Nach Verlassen des Fluidkanals 30 der Kühlstruktur über die jeweilige Ausgangsöffnungen 32 wird das Fluid in ein weitere Schalenelement eingeleitet, das den ausleitenden Teil 42 der Verteilstruktur bildet, und parallel zum einleitenden Teil 41 verläuft. Dadurch wird einem Paar aus zwei Reihen benachbarter Ausgangsöffnungen 42 der ausleitende Teil der Verteilstruktur 40 zur Verfügung steht.

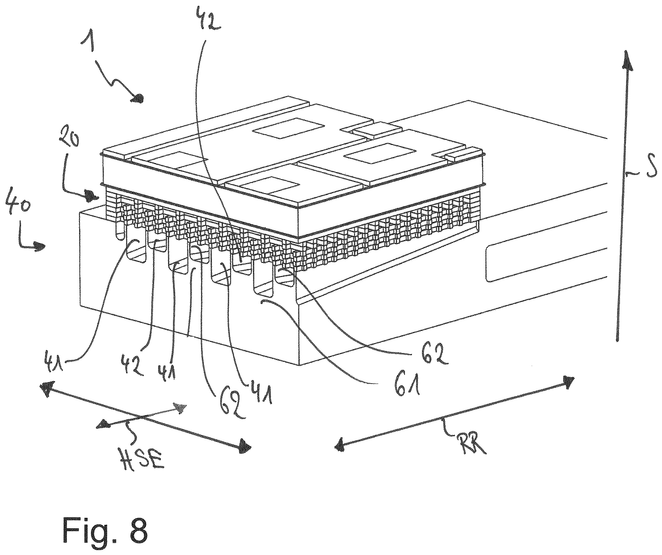

In der Figur 8 ist eine perspektivische Darstellung des Systems aus Figur 7 dargestellt. Insbesondere sind hierbei die nebeneinander angeordneten Schalenelemente bzw. Kanäle zu erkennen, die abwechselnd den einleitenden Teil 41 und den ausleitenden Teil 42 bilden. Dabei unterscheiden sich der einleitende Teil 41 und der ausleitende Teil 42 jeweils voneinander durch ihre Neigungen des rampenförmig ausgebildeten Bodens 61. Vorzugsweise sind der rampenförmige Boden des einleitenden Teils 41 und der rampenförmige Boden des ausleitenden Teils 42 jeweils entgegengesetzt ausgerichtet. Dabei können vorzugsweise die rampenförmigen Böden 61 um denselben absoluten Winkel geneigt sein. Beispielsweise verlaufen die rampenförmigen Böden 61 aller einleitenden Teile 41 parallel und die rampenförmigen Böden 61 aller ausleitenden Teile 42 parallel zueinander. Die Neigung der Böden 61 dient insbesondere der Steuerung einer Strömungsgeschwindigkeit innerhalb der Verteilstruktur. Alternative oder ergänzend wäre es auch vorstellbar, dass zur Anpassung der Strömungsgeschwindigkeit die Schalenelemente in Strömungsrichtung verjüngen, d. h. ihre Breite wird verkleinert. Insbesondere sind hier Metalllagen in der Figur 8 zu erkennen.

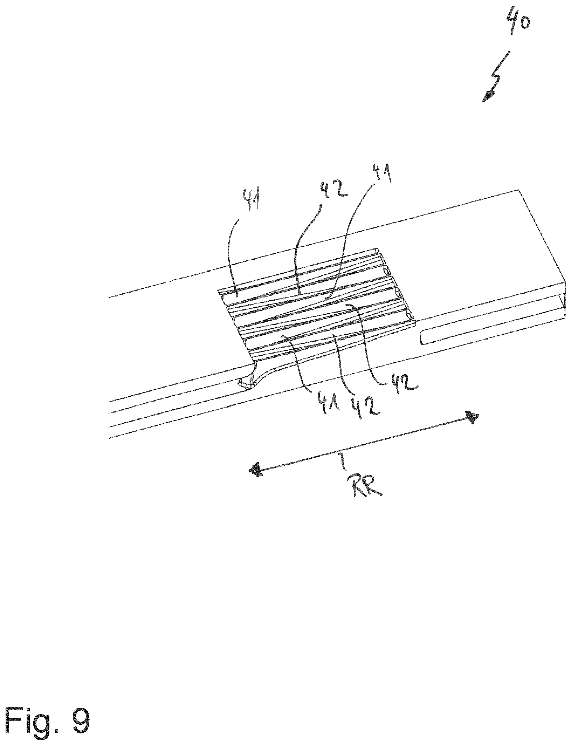

In Figur 9 ist die Verteilstruktur 40 des Systems aus den Figuren 7 und 8 schematisch dargestellt. Hier erfolgt ein Zuführen und Abführen des Fluids von der Seite, beispielsweise über hier vorgesehene Anschlüsse.

### Bezugszeichenliste:

- 1: Metall-Keramik-Substrat
- 4: Bauteil
- 5: Bauteilseite
- 6: Kühlseite
- 11: Keramikschicht
- 12: Metallisierungsschicht
- 13: Sekundärschicht
- 15: Zwischenschicht
- 20: Kühlstruktur
- 30: Fluidkanal
- 31: Eingangsöffnung
- 32: Ausgangsöffnung
- 33: Querbereich
- 34: Schenkelbereiche
- 40: Verteilstruktur
- 41: einleitender Teil
- 42: ausleitender Teil
- 50: Zuführstruktur
- 61: Boden
- 62: Seiten
- T1: erster Teilbereich
- T2: zweiter Teilbereich
- Q: Querrichtung
- Q1: erste Querschnittsöffnung
- Q2: zweite Querschnittsöffnung
- HS1: erste Hauptströmungsrichtung
- HS2: zweite Hauptströmungsrichtung
- HSE: Haupterstreckungsebene
- S: Stapelrichtung

## Patentansprüche

1. System zum Kühlen eines Metall-Keramik-Substrats (1) mit einer Bauteilseite (5) und einer der Bauteilseite (5) gegenüberliegenden Kühlseite (6), umfassend
- eine metallische Kühlstruktur (20) mit mindestens einem integrierten Fluidkanal (30) zur Führung eines Fluids innerhalb der Kühlstruktur (20) und
- eine Verteilstruktur (40) aus Kunststoff zur Versorgung des Fluidkanals (30) mit dem Fluid,
wobei die Kühlstruktur (20) an seiner der Verteilstruktur (40) zugewandten Außenseite (A) eine Eingangsöffnung (31) und eine von der Eingangsöffnung (31) separate Ausgangsöffnung (32) aufweist, wobei die Eingangsöffnung (31) und die Ausgangsöffnung (32) über den Fluidkanal (30) miteinander verbunden sind und der Fluidkanal (30) derart gestaltet ist, dass das Fluid in der verbauten Kühlstruktur von der Eingangsöffnung (31) in Richtung der Bauteilseite (5) geführt und innerhalb der Kühlstruktur (20) umgelenkt wird, wobei mehrere Fluidkanäle (30) mit jeweils einer Eingangsöffnung (31) in einer Reihenrichtung (RR) gesehen nebeneinander angeordnet sind und/oder die Verteilstruktur (40) derart gestaltet ist, dass sie mehrere Eingangsöffnungen mit dem Fluid versorgt.

2. System gemäß Anspruch 1, wobei die Kühlstruktur (20), insbesondere der Fluidkanal (30), und/oder die Verteilstruktur (40) derart gestaltet sind, dass eine Strömungsrichtung des Fluids nach Verlassen der Verteilstruktur (40) in einer parallel zu einer Haupterstreckungsebene (HSE) der Kühlstruktur (20) verlaufenden Richtung seitlich versetzt ist gegenüber einer Strömungsrichtung des Fluid beim Eintritt in die Verteilstruktur (30).

3. System gemäß einem der vorhergehenden Ansprüche, wobei der Fluidkanal (30) U-förmig gestaltet ist, wobei der U-förmig gestaltete Fluidkanal (30) zwei im Wesentlichen senkrecht zur Haupterstreckungsebene (HSE) verlaufende Schenkelbereiche (34) und mindestens einen die beiden Schenkelbereiche (34) verbindenden Querbereich (33) aufweist.

4. System gemäß Anspruch 3, wobei sich ein parallel zur Haupterstreckungsebene (HSE) verlaufender Öffnungsquerschnitt der Schenkelbereiche (34) entlang einer Strömungsrichtung innerhalb der Kühlstruktur (30) seitlich verlagert, insbesondere umfasst der Schenkelbereich (34) einen ersten Teilabschnitt (T1) mit einem ersten Öffnungsquerschnitt (Q1) und einen zweiten Teilabschnitt (T2) mit einem zweiten Öffnungsquerschnitt (Q2), wobei der erste Öffnungsquerschnitt (Q1) zum zweiten Öffnungsquerschnitt (Q2) in einer parallel zur Haupterstreckungsebene (HSE) verlaufenden Richtung gesehen um einen Versatzabstand (V) versetzt ist

5. System gemäß Anspruch 3 oder 4, wobei zumindest einer der Schenkelbereiche (34) zur Verwirbelung des Fluids zumindest bereichsweise einen im Wesentlichen spiralförmigen Verlauf aufweist.

6. System gemäß einem der Ansprüche 2 bis 5, wobei die Verteilstruktur (40) eine an der Kühlstruktur (20) anliegende wandartige Struktur aufweist, wobei die wandartige Struktur gegenüber der Reihenrichtung (RR) um weniger als 15 ° geneigt ist, vorzugsweise parallel zur Reihenrichtung verläuft.

7. System gemäß einem der vorhergehenden Ansprüche, wobei die Verteilstruktur (40) zwei benachbarte Reihen von Eingangsöffnungen (30) mit dem Fluid versorgt.

8. Metall-Keramik-Substrat (1) mit einer Bauteilseite (5) und einer der Bauteilseite (5) gegenüberliegenden Kühlseite (6), wobei das Metall-Keramik-Substrate (1) eine sich entlang einer Haupterstreckungsebene (HSE) erstreckende Keramikschicht (11) und Metallisierungsschicht (12) aufweist, wobei die Kühlseite (6)
- eine metallische Kühlstruktur (20) mit mindestens einem integriertem Fluidkanal (30) zur Führung eines Fluids und
- eine Verteilstruktur (40) aus Kunststoff, zur Versorgung des Fluidkanals (30) mit dem Fluid,
wobei die Kühlstruktur (20) an seiner der Verteilstruktur (40) zugewandten Außenseite (A) eine Eingangsöffnung (31) und eine von der Eingangsöffnung (31) separate Ausgangsöffnung (32) aufweist, wobei die Eingangsöffnung (31) und die Ausgangsöffnung (32) über den Fluidkanal (30) miteinander verbunden sind und der Fluidkanal (30) derart gestaltet ist, dass das Fluid in der verbauten Kühlstruktur von der Eingangsöffnung (31) in Richtung der Bauteilseite (5) geführt und innerhalb der Kühlstruktur (20) umgelenkt wird, wobei mehrere Fluidkanäle (30) mit jeweils einer Eingangsöffnung (31) in einer Reihenrichtung (RR) gesehen nebeneinander angeordnet sind und/oder die Verteilstruktur (40) derart gestaltet ist, dass sie mehrere Eingangsöffnungen mit dem Fluid versorgt.

9. Verfahren zur Herstellung eines Systems gemäß einem der Ansprüche 1 bis 7 oder eines Metall-Keramik-Substrats nach einem der Ansprüche 8 oder 9, wobei die Kühlstruktur (20) mit dem mindestens einen Fluidkanal (30) durch einen Schichtaufbau und/oder durch ein 3D - Druckverfahren hergestellt wird.

## Claims

1. A system for cooling a metal-ceramic substrate (1) including a component side (5) and a cooling side (6) opposite thereto, comprising
- a metallic cooling structure (20) having incorporated at least one fluid channel (30) for guiding a fluid through the cooling structure (20) and
- a distribution structure (40) made of plastic material for supplying the fluid channel (30) with the fluid,
the cooling structure (20), on its outer side (A) facing the distribution structure (40), including an inlet opening (31) and an outlet opening (32) separated from the inlet opening (31), the inlet opening (31) and the outlet opening (32) being connected to each other via the fluid channel (30), and the fluid channel (30) being designed such that the fluid located in the incorporated cooling structure is guided from the input opening (31) in the direction of the component side (5) and is deflected within the cooling structure (20), wherein a plurality of fluid channels (30), each having an input opening (31), are arranged adjacent to each other, as viewed in a row direction (RR), and/or the distribution structure (40) is designed for supplying the fluid to a plurality of input openings.

2. The system according to claim 1, wherein the cooling structure (20), especially the fluid channel (30), and/or the distribution structure (40) are designed such that a flow direction of the fluid after leaving the distribution structure (40) is laterally offset in a direction parallel to a main extension plane (HSE) of the cooling structure (20) with respect to a flow direction of the fluid when entering the distribution structure (30).

3. The system according to one of the preceding claims, wherein the fluid channel (30) is U-shaped, the U-shaped fluid channel (30) having two leg portions (34) extending substantially perpendicular to the main extension plane (HSE) and at least one transverse portion (33) connecting the two leg portions (34).

4. The system according to claim 3, wherein an opening cross section of the leg portions (34) extending parallel to the main extension plane (HSE) is laterally displaced along a flow direction within the cooling structure (30), the leg portion (34) especially comprising a first partial section (T1) having a first opening cross-section (Q1) and a second partial section (T2) having a second opening cross-section (Q2), the first opening cross-section (Q1) being offset in relation to the second opening cross-section (Q2) by an offset distance (V), as viewed in a direction extending parallel to the main extension plane (HSE).

5. The system according to claims 3 or 4, wherein at least one of the leg portions (34), at least in some regions, has a substantially spiral course for swirling the fluid.

6. The system according to one of claims 2 to 5, wherein the distribution structure (40) comprises a wall-like structure abutting the cooling structure (20), wherein the wall-like structure is inclined with respect to the row direction (RR) by less than 15 degrees, and preferably extending parallel to the row direction.

7. The system according to one of the preceding claims, wherein the fluid is supplied to two adjacent rows of input opening (30) via the distribution structure (40).

8. The metal-ceramic substrate (1) including a component side (5) and a cooling side (6) opposite thereto, wherein the metal-ceramic substrate (1) comprises a ceramic layer (11) and metallization layer (12) extending along a main extension plane (HSE), wherein the cooling side (6) comprises
- a metallic cooling structure (20) including at least one incorporated fluid channel (30) for guiding a fluid, and
- a distribution structure (40) made of plastic material for supplying the fluid to the fluid channel (30),
the cooling structure (20), on its outer side (A) facing the distribution structure (40), including an inlet opening (31) and an outlet opening (32) separated from the inlet opening (31), the inlet opening (31) and the outlet opening (32) being connected to each other via the fluid channel (30), and the fluid channel (30) being designed such that the fluid located in the incorporated cooling structure is guided from the input opening (31) in the direction of the component side (5) and is deflected within the cooling structure (20), wherein a plurality of fluid channels (30), each including an input opening (31), are arranged adjacent to each other, as seen in a row direction (RR), and/or the distribution structure (40) is designed such that the fluid is supplied to a plurality of input openings.

9. A method for producing a system according to one of claims 1 to 7 or a metal-ceramic substrate according to one of claims 8 or 9, wherein the cooling structure (20) including the at least one fluid channel (30) is produced using layer build-up and/or a 3D printing method.

## Revendications

1. Système de refroidissement d'un substrat métal-céramique (1), présentant un côté pièce (5) et un côté refroidissement (6) opposé au côté pièce (5), comprenant
- une structure de refroidissement métallique (20) ayant au moins un canal à fluide (30) intégré destiné à guider un fluide à l'intérieur de la structure de refroidissement (20), et
- une structure de distribution (40) en matière plastique, destinée à alimenter le canal à fluide (30) en fluide,
dans lequel
la structure de refroidissement (20) présente sur son côté extérieur (A), tourné vers la structure de distribution (40), une ouverture d'entrée (31) et une ouverture de sortie (32) séparée de l'ouverture d'entrée (31), l'ouverture d'entrée (31) et l'ouverture de sortie (32) étant reliées l'une à l'autre par le canal à fluide (30), et le canal à fluide (30) étant conçu de telle sorte que le fluide dans la structure de refroidissement installée est guidé depuis l'ouverture d'entrée (31) en direction du côté pièce (5) et est renvoyé à l'intérieur de la structure de refroidissement (20),
plusieurs canaux à fluide (30) ayant chacun une ouverture d'entrée (31) sont disposés les uns à côté des autres, vus dans une direction de rangée (RR), et/ou la structure de distribution (40) est conçue de manière à alimenter en fluide plusieurs ouvertures d'entrée.

2. Système selon la revendication 1,
dans lequel la structure de refroidissement (20), en particulier le canal à fluide (30), et/ou la structure de distribution (40) sont conçus de telle sorte qu'une direction d'écoulement du fluide après avoir quitté la structure de distribution (40) est décalée latéralement dans une direction, parallèle à un plan d'extension principale (HSE) de la structure de refroidissement (20), par rapport à une direction d'écoulement du fluide lors de son entrée dans la structure de distribution (30).

3. Système selon l'une des revendications précédentes,
dans lequel le canal à fluide (30) est conçu en forme de U, le canal à fluide (30) conçu en forme de U comportant deux zones de branche (34) sensiblement perpendiculaires au plan d'extension principale (HSE) et au moins une zone transversale (33) reliant les deux zones de branche (34).

4. Système selon la revendication 3,
dans lequel une section transversale d'ouverture des zones de branche (34), parallèle au plan d'extension principale (HSE), se déplace latéralement le long d'une direction d'écoulement à l'intérieur de la structure de refroidissement (30), en particulier, la zone de branche (34) comprend une première portion partielle (T1) ayant une première section transversale d'ouverture (Q1) et une deuxième portion partielle (T2) ayant une deuxième section transversale d'ouverture (Q2), la première section transversale d'ouverture (Q1) étant décalée par rapport à la deuxième section transversale d'ouverture (Q2) d'une distance de décalage (V), vue dans une direction parallèle au plan d'extension principale (HSE).

5. Système selon la revendication 3 ou 4,
dans lequel l'une au moins des zones de branche (34) présente au moins localement un tracé sensiblement en spirale pour faire tourbillonner le fluide.

6. Système selon l'une des revendications 2 à 5,
dans lequel la structure de distribution (40) présente une structure en forme de paroi en appui contre la structure de refroidissement (20), la structure en forme de paroi étant inclinée de moins de 15° par rapport à la direction de rangée (RR), de préférence s'étendant parallèlement à la direction de rangée.

7. Système selon l'une des revendications précédentes,
dans lequel la structure de distribution (40) alimente en fluide deux rangées adjacentes d'ouvertures d'entrée (30).

8. Substrat métal-céramique (1) ayant un côté pièce (5) et côté refroidissement (6) opposé au côté pièce (5), le substrat métal-céramique (1) présentant une couche céramique (11) et une couche de métallisation (12) qui s'étendent le long d'un plan d'extension principale (HSE), le côté refroidissement (6) présentant
- une structure de refroidissement métallique (20) ayant au moins un canal à fluide (30) intégré destiné à guider un fluide, et
- une structure de distribution (40) en matière plastique, destinée à alimenter le canal à fluide (30) en fluide,
dans lequel
la structure de refroidissement (20) présente sur son côté extérieur (A), tourné vers la structure de distribution (40), une ouverture d'entrée (31) et une ouverture de sortie (32) séparée de l'ouverture d'entrée (31), l'ouverture d'entrée (31) et l'ouverture de sortie (32) étant reliées l'une à l'autre par le canal à fluide (30), et le canal à fluide (30) étant conçu de telle sorte que le fluide dans la structure de refroidissement installée est guidé depuis l'ouverture d'entrée (31) en direction du côté pièce (5) et est renvoyé à l'intérieur de la structure de refroidissement (20),
plusieurs canaux à fluide (30) ayant chacun une ouverture d'entrée (31) sont disposés les uns à côté des autres, vus dans une direction de rangée (RR), et/ou la structure de distribution (40) est conçue de manière à alimenter en fluide plusieurs ouvertures d'entrée.

9. Procédé de fabrication d'un système selon l'une des revendications 1 à 7 ou d'un substrat métal-céramique selon l'une des revendications 8 ou 9, dans lequel la structure de refroidissement (20) ayant ledit au moins un canal à fluide (30) est fabriquée par une construction en couches et/ou par un procédé d'impression 3D.
